# EUROPEAN PATENT APPLICATION

(11) **EP 3 955 345 A1**
(43) Date of publication of application: **16.02.2022**
(21) Application number: 19950036.4
(22) Date of filing: 19.12.2019
(51) Int. Cl.: H01M 4/48, H01M 4/1391

(54) **SILICON-OXYGEN PARTICLE FOR ELECTRODE MATERIAL, PREPARATION METHOD THEREFOR AND USE THEREOF**

(30) Priority: 22.10.2019 CN 201911007418
(71) Applicant: Amprius (Nanjing) Co., Ltd., Jiangsu 210006 (CN)
(72) Inventor: LI, Zhe, Nanjing, Jiangsu 210006 (CN); WANG, Cen, Nanjing, Jiangsu 210006 (CN); WANG, Fang, Nanjing, Jiangsu 210006 (CN); ZHANG, Hebao, Nanjing, Jiangsu 210006 (CN)
(74) Representative: Kurig, Thomas
(86) International application number: PCT/CN2019/126660
(87) International publication number: WO 2021/077586

(57) **Abstract**

The present invention relates to a silicon oxide particle for an electrode material, characterized by including: silicon suboxide particles with a general formula of SiOx; and a carbon layer, wherein a plurality of silicon suboxide particles are bonded by the carbon layer, and the plurality of silicon suboxide particles are bonded and meanwhile coated by the carbon layer. The silicon oxide particle according to the present invention is dense, with narrow particle size distribution and small specific surface area, and has advantages such as high capacity, high Coulombic efficiency, low swelling rate and high capacity retention.

## Description

### TECHNICAL FIELD

The present invention relates to the field of batteries, and in particular, relates to silicon oxide particle for a lithium-ion electrode material, a method for preparing the same and an application thereof.

### BACKGROUND

In recent years, with the rapid development and widespread application of a variety of portable electronic devices, electric vehicles and energy storage systems, there is an increasingly urgent demand for a lithium-ion battery with high energy density and long cycle life. At present, the negative-electrode material for commercial lithium-ion batteries is mainly graphite, which, however due to its low theoretical capacity, limits the further improvement of the energy density of the lithium-ion batteries. A silicon negative-electrode material due to its unparalleled advantage of higher capacity than other negative electrode materials has become a hotspot in research and development in recent years, and has gradually moved from the research and development in laboratories to commercial applications. Moreover, a silicon negative-electrode material has a severe volume effect during lithium intercalation and deintercalation, with a volume change rate of about 300%, which will lead to pulverization of the electrode material and separation of the electrode material from a current collector. In addition, the silicon negative-electrode material continuously expands and shrinks during the charging and discharging of batteries which leads to constantly cracks. When fresh interfaces exposed to electrolyte, new SEI forms to continuously consume the electrolyte, therefore resulting in poor cycle performance of the electrode material.

An existing silicon negative-electrode material is featured with low Coulombic efficiency, large swelling rate, low cycling capacity retention, large electrochemical polarization and complicated preparation process, and thus can hardly be commercially applied to the batteries, which is also a technical challenge in the art.

### SUMMARY

In light of the defects of the prior art, one of the objects of the present invention is to provide a silicon-oxide composite material for a lithium-ion battery with high capacity, high Coulombic efficiency, long cycle life and low swelling rate, and a method for preparing the same.

Specifically, the present invention provides a silicon oxide particle for an electrode material. The particle has a dense structure without pores above a sub-micron level, and is characterized by including:

Silicon suboxide particles with a general formula of SiOx, wherein the silicon suboxide particles are prepared, for example, from a starting material of amorphous silicon suboxide powder through a disproportionation reaction, whereby silicon nanocrystals/amorphous nanoclusters embedded in a SiOx matrix are formed;

A carbon layer, wherein a plurality of silicon suboxide particles are bonded by the carbon layer, and the plurality of silicon suboxide particles bonded by the carbon layer are coated with the carbon layer. Specifically, each silicon oxide particle is a secondary particle formed by combining a plurality of silicon suboxide particles and a carbon film, and there is no individual silicon suboxide primary particle or no silicon suboxide primary particle coated with the carbon layer.

Specifically, a material of the carbon layer is obtained by carbonizing one or a combination of more precursor materials selected from a group consisting of glucose, sucrose, chitosan, starch, critic acid, gelatin, alginic acid, carboxymethyl cellulose, coal pitch, petroleum pitch, phenolic resin, tar, naphthalene oil, anthracene oil, polyacrylic acid, polyacrylic ester, polystyrene, polyvinylpyrrolidone, polyoxyethylene, polyvinyl alcohol, epoxy resin, polyacrylonitrile, and polymethyl methacrylate.

Specifically, for the silicon suboxide particles, 0.5≤x≤1.5, preferably 0.8≤x≤1.2. More preferably, 0.9≤x≤1.1.

Further, a median particle size D50 of the silicon suboxide particles is between 0.05 µm and 20 µm, preferably between 0.3 µm and 10 µm. More preferably, the silicon suboxide particles have D50 is between 3 µm and 8 µm and D90 between3.5 µm and 15 µm.

Specifically, a mass ratio of the silicon suboxide particles to the silicon oxide particle is in the range of 80 wt% to 99.9 wt%, preferably in the range of 90 wt% to 99.5 wt%. More preferably, a mass ratio of the silicon suboxide particles to the silicon oxide particle is in the range of 94 wt% to 98 wt%.

Further, the silicon oxide particle further includes a conductive agent uniformly dispersed inside and/or on the outer surface of the silicon oxide particle.

Specifically, the conductive agent may be one or a combination of more selected from a group consisting of Super P, Ketjen black, vapor grown carbon fibers, acetylene black, conductive graphite, carbon nanotubes and graphene.

Specifically, a mass ratio of the conductive agent to the silicon oxide particle is in an amount from 0.01 wt% to 10 wt%, preferably from 0.03 wt% to 5 wt%.

Further, the silicon oxide particle further includes one or more, preferably one, additional carbon layers coating on the outer surface of the silicon oxide particle.

Specifically, the additional carbon layer is obtained by carbonizing one or a combination of more precursor materials selected from a group consisting of coal pitch, petroleum pitch, polyvinyl alcohol, epoxy resin, polyacrylonitrile and polymethyl methacrylate.

Optionally, the additional carbon layer is obtained by performing chemical vapor deposition using any one or a combination of more selected from a group consisting of methane, ethane, ethylene, acetylene, propane, propylene, butane, butene, butadiene, benzene, toluene, xylene, styrene or phenol.

Further, a mass ratio of the additional carbon layer to the silicon oxide particle is in the range of 0.1 wt% to 10wt%, preferably in the range of 0.3 wt% to 6wt%.

Further, for any of the silicon oxide particles as previously defined, the silicon oxide particle has D50 between 1 µm and 40 µm, preferably between 3µm and 20 µm.

Further, the silicon oxide particle has a narrow particle size distribution with a span value (SPAN) = (D90-D10)/D50≤1.4, preferably, (D90-D10)/D50≤1.35.

Preferably, the specific surface area of the silicon oxide particle is in the range of 0.1 m²/g to 10 m²/g, more preferably in the range of 0.3 m²/g to 6 m²/g.

Further, a tap density of the silicon oxide particles is ≥0.6 g/cm³, preferably ≥0.8 g/cm³.

More specifically, for any of the silicon oxide particles as previously defined, the silicon oxide particle preferably has D50 between 3.5 µm and 10 µm, SPAN between 0.9 and 1.35, the specific surface area in the range of 0.8 m²/g to 2.7 m²/g.

More preferably, the silicon oxide particle has D10 between 3.5 µm and 5.5 µm, D50 between 6.0 µm and 10 µm, SPAN between 0.9 and 1.2, the specific surface area in the range of 0.9 m²/g to 1.6 m²/g, the tap density in the range of 0.95 m²/g to 1.2 g/cm³, and the carbon content in an amount from 2 wt% to 6.5wt%. Most preferably, D10 between 4.0 µm and 5.0 µm, D50 between 6.5 µm and 9 µm, SPAN between 0.9 and 1.1, the specific surface area in the range of 0.9 m²/g to 1.4 m²/g, the tap density in the range of 1.0 m²/g to 1.2 g/cm³, and the carbon content in an amount from 2.5 wt% to 5.5wt%.

The present invention further provides an application of any of the silicon oxide particles as previously defined in an electrode material.

The present invention further provides a negative-electrode material including any of the silicon oxide particles as previously defined. Moreover, the negative-electrode material is prepared by mixing the silicon oxide particle with a carbon-based powder material, wherein the carbon-based powder material may be one or an arbitrary combination of more selected from natural graphite, artificial graphite, surface-modified natural graphite, hard carbon, soft carbon or mesocarbon microbeads.

The present invention further provides an electrode or battery including any of the negative-electrode materials as previously defined, which specifically may be a lithium-ion battery.

The present invention further provides a method for preparing the silicon oxide particle as previously defined. The method includes: mixing and granulating silicon suboxide particles with a carbon-layer precursor material or several carbon-layer precursor materials, carbonizing the composite particles in a non-oxidizing atmosphere, and pulverizing and sieving the carbonization product, and removing magnetic impurities.

Further, the method for preparing the silicon oxide particle as previously defined may further include adding a conductive agent, specifically, mixing and granulating the silicon suboxide particles, the conductive agent and the carbon-layer precursor material, then carbonizing the composite material in a non-oxidizing atmosphere, and pulverizing and sieving the carbonization product, and removing magnetic impurities.

Further, the method as previously defined further includes a step of coating the silicon oxide particle with one or more, preferably one, additional carbon layers.

Specifically, the granulating process may be performed by using a granulating device having both heating and stirring functions, and includes, but not limited to, a VC mixer, a mechanical fusion machine, a coating machine or a reactor. Specifically, a linear velocity at the maximum diameter of a stirring component in the VC mixer, mechanical fusion machine, coating machine or reactor is in the range of 1 m/s to 30 m/s during the granulating process performed at a temperature that may be selected between 100°C and 1050°C, for 0.5 hours to 10 hours, under protection of an inert atmosphere. In this process, a carbon precursor material is softened and then uniformly coated on the surfaces of the silicon suboxide particles under continuous high-speed stirring; and meanwhile, the plurality of silicon suboxide primary particles coated with the carbon precursor material are bonded with one another to form silicon suboxide /carbon precursor composite secondary particles of a certain size. The secondary particles above become denser and denser under long-time and high-frequency shearing, extruding and colliding in the VC mixer, mechanical fusion machine, coating machine or reactor, and meanwhile, carbon precursors under heating are deprived of small-molecule volatiles and partially cross-linked and carbonized to shape the secondary particles.

Specifically, the granulating device may be also a spraying dryer. Here, when the spraying dryer processes slurry containing the silicon suboxide particles and carbon precursors, a nozzle of the spraying dryer atomizes the slurry into small droplets, in which a solvent quickly evaporates in the hot air at a certain temperature in the spraying dryer, thereby obtaining dried silicon suboxide/carbon precursor composite secondary particles through cyclone collector.

Further, a carbonization device includes a tube furnace, an atmosphere chamber furnace, a pusher kiln, a roller kiln or a rotary furnace.

Specifically, a carbonization reaction occurs at a temperature between 600°C and 1200°C for 0.5 hours to 24 hours.

Specifically, the non-oxidizing atmosphere is provided by at least one gas selected from nitrogen, argon, hydrogen and helium.

Specifically, a device used during the pulverization includes any one selected from a jet mill, a ball mill, a turbo mill, a Raymond mill, a plow blender and a fluted-disk mill.

Specifically, a device for coating the silicon oxide particle with the additional carbon layer may be selected as having both heating and stirring functions, and include, but not limited to, any one selected from the mechanical fusion machine, the VC mixer, a high-speed disperser, a coating machine or a reactor.

Further, a process for coating the silicon oxide particle with the additional carbon layer may be selected from a chemical vapor deposition method, which includes: performing chemical vapor deposition in an organic gas and/or vapor atmosphere at a temperature between 700°C and 1050°C.

Compared with the prior art, the present invention has the following advantages.

In the present invention, the silicon suboxide particles are tightly bonded into aggregated particles through the carbon layer, which reduces the proportion of small-sized primary particles without excessively increasing the proportion of large-sized secondary particles, and obtains the secondary particles with narrower particle-size distribution. Due to the process of preparing the secondary particles, the selection criteria of the starting material of silicon suboxide particles is expanded. Moreover, the technical solution of the present invention further greatly reduces the specific surface area of the particles, which consequently decreases the contact area of the particles with the electrolyte in a battery (such as a lithium-ion secondary battery), and reduces the consumption of reversible lithium ions caused by the constant generation of SEI on the material surface during each charging and discharging. In such a way, the Coulombic efficiency is increased and the cycle performance is improved.

The connection and coating by the carbon layer provides excellent diffusion paths for both electrons and lithium ions, ensuring that the silicon suboxide primary particles inside the secondary particles are fully involved in the electrochemical reaction, which reduces the polarization of the battery and increases the rate capability. The conductive agent dispersed inside and on the surfaces of the secondary particles further improves the conductivity of the material, leading to a better rate capability of the battery.

The silicon oxide composite material has higher capacity and swelling rate than those of a carbon-based negative electrode mixed therewith. Therefore, after it is prepared into an electrode, the micro-area where the silicon oxide composite material is located has a higher areal capacity and larger swelling. Compared with silicon oxide composite materials prepared through other methods, the particles prepared according to the present invention have narrower particle-size distribution with lower portion of large particles. As a result, after the particles according to the present invention are prepared into an electrode, the distribution of areal capacity and swelling on the electrode is comparatively more even, so that the swelling rate of the electrode is lower.

In the present invention, a continuous carbon layer coated on the outer surface of the particle further reduces the specific surface area of the silicon oxide composite material while increasing the conductivity of the material, and reduces the formation of SEI, which is conducive to improving the Coulombic efficiency and the cycling performance of the battery. Due to more stable particle structure and smaller swelling, the material according to the present invention allows the addition of more silicon oxide particles in the negative electrode material, so as to improve the energy density of the battery.

### BRIEF DESCRIPTION OF THE DRAWINGS

FIG. 1 is a high magnification scanning electron microscope (SEM) image of a secondary particle prepared according to Example 1.
FIG. 2 is a schematic illustration of the secondary particle prepared according to Example 1.
FIG. 3 is a schematic illustration of the secondary particle prepared according to Example 2.
FIG. 4 is a schematic illustration of the secondary particle prepared according to Example 4.
FIG. 5 is a diagram showing particle size distribution curves of a starting material of silicon suboxide used in Comparative Example 2 and Example 6, and secondary particles prepared in Comparative Examples 1 and 2 and Example 6.
FIG. 6 is a low magnification SEM image of secondary particles prepared according to Example 6.
FIG. 7 is a high magnification SEM image of secondary particles prepared according to Example 6.
FIG. 8 is an SEM image showing a cross section of a negative electrode after the formation of a battery containing the secondary particles prepared according to Example 6.
FIG. 9 is a high magnification SEM image of secondary particles prepared according to Example 14.
FIG. 10 is a SEM image of particles prepared according to Comparative Example 1.
FIG. 11 is a SEM image of particles prepared according to Comparative Example 2.

### DETAILED DESCRIPTION OF EMBODIMENTS

Specific embodiments of the present invention will be illustrated below in more detail in combination with examples for a better understanding of the solutions of the present invention as well as the advantages thereof in various aspect. Nevertheless, the specific embodiments and examples described below are merely for illustrative purposes, and are not intended to limit the present invention.

### Example 1

### 1. Preparation Method

### 1.1 Preparation of secondary particles

100 kg of silicon suboxide powder (i.e., primary particles, with D10=0.60 µm, D50=1.78 µm, D90=3.59 µm, SPAN=1.68 and a specific surface area of 8.9 m²/g, and with x=1 in the general formula SiOx) together with 12 kg of coal pitch powder were added to a VC mixer, and mixed for 30 min at a linear velocity of 16 m/s at the maximum diameter of a stirring component, to uniformly mix the two starting materials. Subsequently, the rotation speed was reduced so that the foregoing linear velocity was reduced to 8 m/s, meanwhile, nitrogen was introduced as an inert protective gas; then the temperature was initially raised to 300°C at a rate of 3°C/min, held for 4h, and then reduced to room temperature through free cooling. Hence, the granulating process of the silicon suboxide and pitch was completed. In this process, the pitch was gradually softened with the increase of the temperature inside the VC mixer, and then uniformly coated on the surface of each of the silicon suboxide primary particle under continuous high-speed stirring; meanwhile, the silicon-suboxide primary particles coated with pitch were bonded and aggregated with one another to form silicon-suboxide/coal pitch composite secondary particles of a certain size. The secondary particles above became denser and denser under long-time shearing, extruding and colliding in the VC mixer, meanwhile, the pitch was deprived of small-molecule volatiles and partially cross-linked and carbonized to shape the secondary particles at the temperature of 300°C.

A resulting intermediate product was loaded into a graphite saggar which was then put in a roller kiln, nitrogen protective gas was introduced, and the temperature was raised to 900°C at a rate of 3°C/min, held for 4h, and then reduced to room temperature through free cooling. Hence, the carbonization was completed. In this step, the pitch was carbonized at high temperature in an oxygen-free atmosphere. A resulting carbonized product was jet-milled, where by adjusting the pressure of the jet, composite material lumps obtained after carbonization were pulverized into fine powder of the secondary particles without destroying the secondary particle structure. Finally, a resultant was sieved and magnetic separation was carried out to obtain a final product applicable to the negative electrode material.

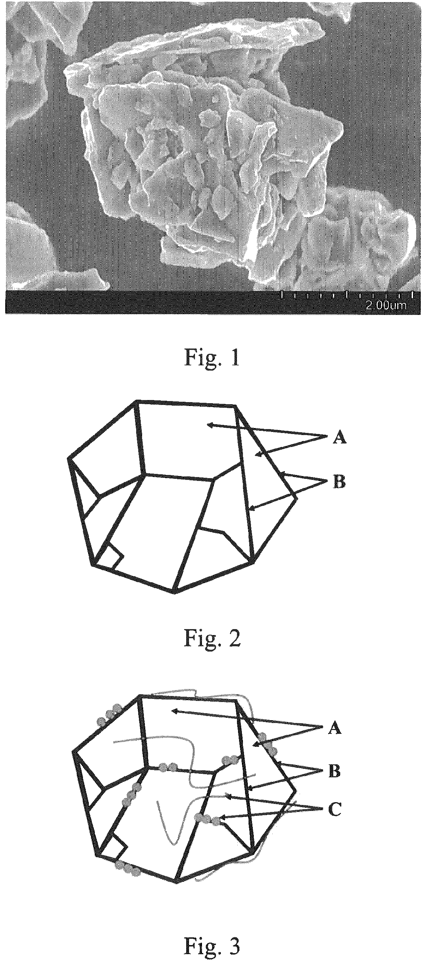

FIG. 1 is a high magnification SEM image of the secondary particle prepared in Example 1, and FIG. 2 is a schematic illustration of said secondary particle. The particles prepared in Example 1 are dense secondary particles that are formed by combining the silicon-suboxide primary particles A with the carbon layer B connecting and coating the same.

### 1.2 Preparation of electrode

9 parts of the foregoing secondary particles, 43.5 parts of artificial graphite, 43.5 parts of natural graphite, 1 part of conductive agent Super P, 0.5 parts of multi-wall carbon nanotubes, 1 part of sodium carboxymethylcellulose (CMC) and 1.5 parts of modified polyacrylic ester as binders were taken and subjected to homogenizing, coating, drying and calendering to obtain a negative electrode containing the silicon oxide secondary particles.

### 2. Product testing

The particle size of the secondary particles were as follows: D10=1.89 µm, D50=4.02 µm, D90=7.16 µm, with SPAN=1.31, the specific surface area of 2.7 m²/g, the tap density of 0.88 g/cm³ and the carbon content of 4.9 wt%. The silicon suboxide material may go through a disproportionation reaction (2SiO →-Si+SiO₂) after thermal treatment at above 800°C to form silicon nano crystals/nanoclusters uniformly dispersing inside SiOx matrix. Based on the X-ray diffraction spectra and Scherrer equation, a grain size corresponding to a Si(111) crystal facet in the material obtained in Example 1 was calculated to be 2.9 nm.

Instruments and devices used in the testing items above were:

Hitachi SU8010 field-emission scanning electron microscope was used to observe the morphology and the like of a sample.

Dandong Bettersize 2000LD laser particle size analyzer was used to test the particle size and particle size distribution of the material.

Quantachrome Nova4200e specific surface area tester was used to test the specific surface area of the material.

Dandong Bettersize BT-301 tap volumeter was used to test the tap density of the material.

Elementar vario EL cube element analyzer was used to determine the carbon content in the material.

Rigaku MiniFlex600 X-ray diffraction instrument was used to test the crystal structure of the material.

### 3. Performance testing

Half cell evaluation: the negative electrode containing the silicon oxide secondary particles as prepared above, a separator, a lithium foil and a stainless-steel gasket were sequentially stacked, added 200 µL of electrolyte dropwise and then sealed to get a 2016 lithium-ion coin cell. The capacity and discharge Coulombic efficiency of the half cell was tested by using a battery testing system from Wuhan LANHE Electronics Co., Ltd. It was tested that the half cell with the above negative electrode had an initial reversible lithium deintercalation capacity of 1593.3 mAh/g, and an initial Coulombic efficiency of 78.6%.

Full cell evaluation: the negative electrode containing the silicon oxide secondary particles as prepared above was cut, vacuum-baked, and then wound and packed with a positive electrode (a ternary material of Ni-Co-Mn, LiNi_{0.8}Co_{0.1}Mn_{0.1}O₂) and a separator into an aluminium-plastic bag of a corresponding size; then a certain amount of electrolyte was added and sealed for formation, thereby obtaining a complete lithium-ion full cell with a negative electrode containing the silicon oxide secondary particles. The capacity and average discharge voltage at 0.2 C discharge rate, and a capacity retention at 1C charge/discharge rate after 500 cycles of the full cell were tested by using a battery tester from Shenzhen New are Electronics Co., Ltd., with a voltage range of 4.2-2.75 V. Weighed the battery, combined with the above electrochemical data, the gravimetric energy density of the full cell was calculated to be 301 Wh/kg. The first Coulombic efficiency is 84.1% and the capacity retention rate is 85.3% after 500 charge/discharge cycles. After 500 cycles, the battery was fully charged and then measured in thickness, and compared with an initial thickness of the battery, a battery swelling rate was calculated to be 9.0%. Then the battery was disassembled in an inert atmosphere and measured the thickness of the negative electrode which was fully intercalated with lithium, and compared with the initial thickness of the negative electrode before the battery is assembled. The swelling rate of the fully charged negative electrode was 29.4%. The results of the above tests were summarized in Table 1.

### Example 2

The process in Example 2 is similar to that in Example 1, with a difference lying in that a conductive agent powder containing 0.3 kg of Ketjen black and 0.2 kg of multi-wall carbon nanotubes was added additionally. Therefore, the final product was silicon-suboxide/amorphous-carbon composite secondary particles containing the conductive agent, with a structure as shown in FIG. 3. These secondary particles were formed by combining the silicon-suboxide primary particles A, the conductive agent C and a carbon layer B for connecting and coating the two, with the conductive agent C uniformly dispersed inside and on the outer surfaces of the secondary particles. The final product had D10=1.78 µm, D50=3.89 µm, D90=7.01 µm, SPAN=1.34, the specific surface area of 3.0 m²/g, the tap density of 0.84 g/cm³ and the carbon content of 5.3 wt%, with a grain size of 2.9 nm corresponding to a Si(111) crystal facet.

The methods for evaluating the half cell and the full cell were the same as in Example 1, and the results were summarized in Table 1. It can be seen that the performances of the batteries are somewhat improved after the addition of the conductive agent.

### Example 3

100 kg of the secondary particles prepared in Example 1 and 1 kg of petroleum pitch powder were added to the VC mixer, and mechanically mixed for 10 minutes at a linear velocity of 3 m/s, which was then reduced to 2 m/s; and introduce a nitrogen protection atmosphere, the temperature of the device was raised to 300°C under stirring and held for 1 h, which was subsequently cooled to room temperature freely. A resulting material coated with the pitch was placed in an inert atmosphere of argon at 400°C, which was held for 2 h, then increased to 900°C for carbonization for 4h and then cooled to room temperature freely; and a resultant was pulverized, sieved and magnetic separation was carried out to obtain silicon-suboxide/amorphous-carbon composite particles having a second amorphous-carbon coating layer. The final product had D10=2.13 µm, D50=4.65 µm, D90=7.87 µm, SPAN=1.23, the specific surface area of 2.4 m²/g, the tap density of 0.95 g/cm³ and the carbon content of 5.8 wt%, with a grain size of 2.9 nm corresponding to a Si(111) crystal facet.

The methods for evaluating the half cell and the full cell were the same as in Example 1, and the results were summarized in Table 1.

### Example 4

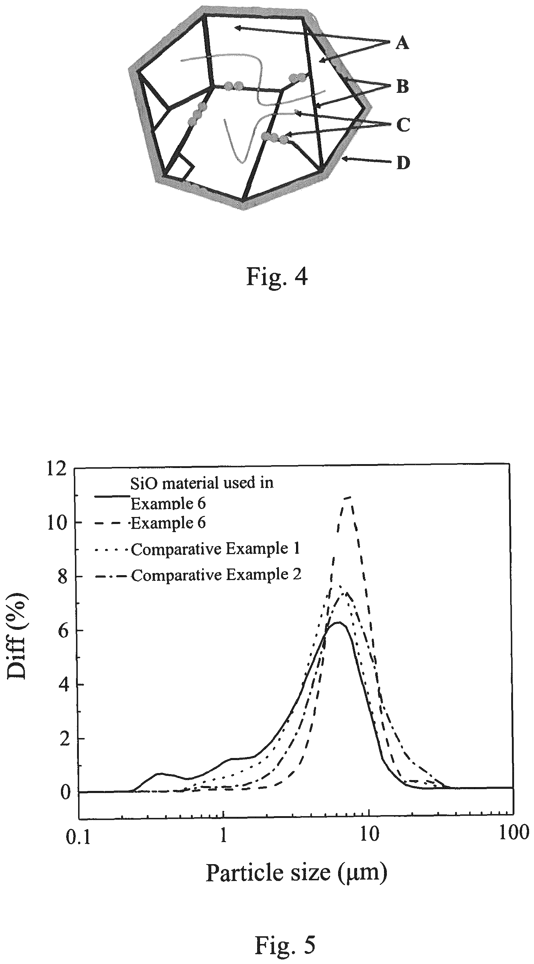

100 kg of the secondary particles prepared in Example 2 were processed with the second coating process in Example 3 to obtain silicon-suboxide/multi-wall carbon nanotubes/Ketjen black/amorphous-carbon composite particles having a second amorphous-carbon coating layer. FIG. 4 is a schematic of the secondary particles prepared in this example. As shown in FIG. 4, these secondary particles were formed by combining the silicon-suboxide primary particles A, the conductive agent C and a carbon layer B for connecting and coating the two, where the conductive agent C was uniformly dispersed inside and on the outer surfaces of the secondary particles, and the outer surfaces of the secondary particles were provided with the second continuous carbon coating layer D. The final product had D10=2.01 µm, D50=4.45 µm, D90=7.76 µm, SPAN=1.29, the specific surface area of 2.7 m²/g, the tap density of 0.89 g/cm³ and the carbon content of 6.2 wt%, with a grain size of 2.9 nm corresponding to a Si(111) crystal facet.

The methods for evaluating the half cell and the full cell were the same as in Example 1, and the results were summarized in Table 1. It can be seen that like Example 3, the product performance can be significantly improved by additional coatings.

### Example 5

0.2 kg of sucrose was dissolved in 8 kg of deionized water to prepare a sucrose solution; then, a carbon nanotube slurry containing 0.6 g of single-wall carbon nanotubes was added to the sucrose solution and dispersed; 2 kg of silicon suboxide powder (the same as in Example 1) was added under stirring; and subsequently, ultrasonic dispersion was performed for 1 h under stirring to prepare a sucrose/single-wall carbon nanotubes/silicon suboxide particle composite slurry. Said composite slurry was spray dried with an inlet-air at 150°C under a nozzle atomizing pressure of 0.2 Mpa. The dry powder of sucrose/single-wall carbon nanotubes/silicon suboxide composite secondary particles was obtained. Said powder was loaded into a graphite saggar which was then put in an atmosphere chamber furnace; nitrogen as an inert protective gas was introduced; and the temperature was raised to 900°C at 3°C/min, held for 6 h, and then cooled to room temperature freely. Hence, the carbonization was completed. A resulting carbonized product was pulverized by a fluted-disk mill, with a maximum linear velocity of 3 m/s at an outer edge of a rotor of the fluted-disk mill. 1 kg of said secondary particles and 0.04 kg of petroleum pitch powder were simply mixed and then added to the mechanical fusion machine for treatment for 0.5 h, where the linear velocity at an outer edge of a rotor was controlled at 15 m/s; a processed product was placed in an inert atmosphere of nitrogen at 400°C, which was held for 2 h, then increased to 900°C for carbonization for 4 h and then cooled to room temperature freely; and a resultant was pulverized, sieved and magnetic separation was carried out to obtain silicon-suboxide/single-wall carbon nanotubes/amorphous-carbon composite particles having a second amorphous-carbon coating layer. The final product had D10=1.90 µm, D50=4.87 µm, D90=8.62 µm, SPAN=1.38, the specific surface area of 3.7 m²/g, the tap density of 0.82 g/cm³ and the carbon content of about 4.8 wt%, with a grain size of 2.9 nm corresponding to a Si(111) crystal facet.

The methods for evaluating the half cell and the full cell were the same as in Example 1, and the results were summarized in Table 1. Taken together, the performance of the battery prepared through spray-drying was improved compared with the prior art, but was not outstanding in some performances compared with other examples in the present invention.

### Example 6

100 kg of silicon suboxide powder (with D10=1.07 µm, D50=4.68 µm, D90=8.84 µm, SPAN=1.66 and a specific surface area of 2.9 m²/g, and with x=1 in the general formula SiOx) together with 5 kg of petroleum pitch powder were added to a vertical coating machine, and mixed for 1 h at a linear velocity of 7 m/s at a maximum diameter of a stirring component, to uniformly mix the two starting materials. Subsequently, the linear velocity was reduced to 3 m/s, meanwhile, nitrogen was introduced as an inert protective gas; and then the temperature was raised to 500°C at a rate of 3°C/min, held for 3 h, and then cooled to room temperature freely. A resulting intermediate product was loaded into a graphite saggar which was then put in a roller kiln, a nitrogen protective gas was introduced, and the temperature was raised to 1020°C at a rate of 3°C/min, held for 2 h, and then cooled to room temperature freely. A resulting carbonized product was pulverized for 1 h by a plow blender, with a linear velocity of the plow blade as 3 m/s. Finally, sieving and magnetic separation magnetic separation were performed to obtain a final product, which had D10=4.32 µm, D50=7.06 µm, D90=10.90 µm, SPAN=0.93, the specific surface area of 1.1 m²/g, the tap density of 1.09 g/cm³ and the carbon content of 3.2 wt%, with a grain size of 4.1 nm corresponding to a Si(111) crystal facet.

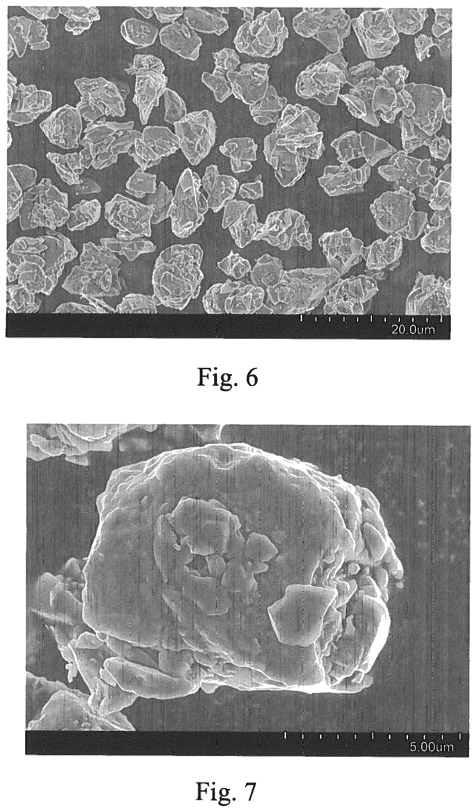

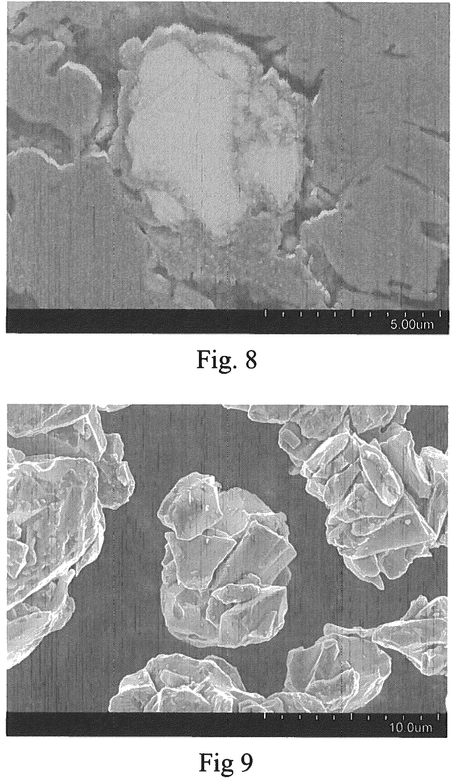

FIG. 5 illustrates the particle size distribution curves of the starting material of silicon suboxide powder and the silicon suboxide composite material (i.e., the secondary particles). In addition, FIG. 6 and FIG. 7 show the SEM images of the secondary particles prepared in this embodiment. FIG. 8 is an SEM image showing a cross section of a negative electrode of a lithium-ion battery containing the secondary particles prepared in this example. From FIG. 6, it can be seen that the particles prepared in this example are secondary particles with uniform size, without small individual primary particles. Referring to both FIG. 7 and FIG. 8, it can be seen that the particles prepared in this example are dense secondary particles.

The methods for evaluating the half cell and the full cell were the same as in Example 1, and the results were summarized in Table 1.

### Example 7

100 kg of silicon suboxide powder (the same as in Example 6) together with 9 kg of polyvinyl alcohol powder were added to the vertical coating machine, and mixed for 2 h at a linear velocity of 5 m/s at the maximum diameter of a stirring component, to uniformly mix the two starting materials. Subsequently, the linear velocity was reduced to 3 m/s, meanwhile, nitrogen was introduced as an inert protective gas; then the temperature was raised to 300°C at a rate of 2°C/min, held for 6 h, and then cooled to room temperature freely. A resulting intermediate product was loaded into a graphite saggar which was then put in a roller kiln, nitrogen protective gas was introduced, and the temperature was raised to 1020°C at a rate of 3°C/min, held for 2 h, and then cooled to room temperature free. A resulting carbonized product was pulverized for 1 h by a plow blender, with a linear velocity of the plow blade as 3 m/s. Finally, sieving and magnetic separation were performed to obtain a final product, which had D10=3.97 µm, D50=6.91 µm, D90=10.40 µm, SPAN=0.93, the specific surface area of 1.2 m²/g, the tap density of 1.05 g/cm³ and the carbon content of 3.0 wt%, with a grain size of 4.1 nm corresponding to a Si(111) crystal facet.

The methods for evaluating the half cell and the full cell were the same as in Example 1, and the results were summarized in Table 1.

### Example 8

100 kg of silicon suboxide powder (with D10=0.87 µm, D50=3.88 µm, D90=7.73 µm, SPAN=1.77 and a specific surface area of 3.8 m²/g, and with x=1 in the general formula SiOx) together with 7 kg of petroleum pitch powder were added to the VC mixer, and mixed for 1 h at a linear velocity of 8 m/s at the maximum diameter of a stirring component, to uniformly mix the two starting materials. Subsequently, the linear velocity was reduced to 4 m/s, meanwhile, nitrogen was introduced as an inert protective gas; then the temperature was raised to 900°C at a rate of 3°C/min, held for 1 h, and then cooled to room temperature freely. A resulting intermediate product was loaded into a graphite saggar which was then put in a pusher kiln, nitrogen protective gas was introduced, and the temperature was raised to 1000°C at a rate of 3°C/min, held for 3 h, and then cooled to room temperature freely. A resulting carbonized product was pulverized for 1 h by a plow blender, with a linear velocity of the plow blade as 3 m/s. Finally, sieving and magnetic separation were performed to obtain a final product, which had D10=4.51 µm, D50=7.15 µm, D90=1 1.07 µm, SPAN=0.92, the specific surface area of 1.0 m²/g, the tap density of 1.12 g/cm³ and the carbon content of 4.0 wt%, with a grain size of 3.9 nm corresponding to a Si(111) crystal facet.

The methods for evaluating the half cell and the full cell were the same as in Example 1, and the results were summarized in Table 1. The full cell had the gravimetric energy density up to 311 Wh/kg, the capacity retention up to 90.7%, and the cell swelling rate of 7.6%. Taken together, the battery prepared in this example had an excellent performance.

### Example 9

The process steps of Example 9 were similar to those of Example 8, with an only difference lying in that in the granulating step, the temperature in the VC mixer was held at 400°C for 3 h. The final product had D 10=4.26 µm, D50=7.46 µm, D90=11.98 µm, SPAN=1.03, the specific surface area of 1.2 m²/g, the tap density of 1.07 g/cm³ and the carbon content of 3.9 wt%, with a grain size of 3.9 nm corresponding to a Si(111) crystal facet.

The methods for evaluating the half cell and the full cell were the same as in Example 1, and the results were summarized in Table 1.

### Example 10

The process steps of Example 10 were similar to those of Example 8, with an only difference lying in that in the granulating step, the temperature in the VC mixer was held at 150°C for 6 h. The final product had D10=4.00 µm, D50=8.47 µm, D90=14.10 µm, SPAN=1.19, the specific surface area of 1.4 m²/g, the tap density of 1.02 g/cm³ and the carbon content of 3.9 wt%, with a grain size of 3.9 nm corresponding to a Si(111) crystal facet.

The methods for evaluating the half cell and the full cell were the same as in Example 1, and the results were summarized in Table 1.

### Example 11

The process steps of Example 11 were similar to those of Example 9, with an only difference lying in that the amount of the added petroleum pitch is 9 kg. The final product had D10=4.78 µm, D50=8.90 µm, D90=14.90 µm, SPAN=1.14, the specific surface area of 1.6 m²/g, the tap density of 1.01 g/cm³ and the carbon content of 6.1 wt%, with a grain size of 3.9 nm corresponding to a Si(111) crystal facet.

The methods for evaluating the half cell and the full cell were the same as in Example 1, and the results were summarized in Table 1.

### Example 12

The process steps of Example 12 were similar to those of Example 9, with an only difference lying in that the amount of the added petroleum pitch is 3 kg. The final product had D10=3.78 µm, D50=6.98 µm, D90=10.76 µm, SPAN=1.00, the specific surface area of 1.1 m²/g, the tap density of 1.11 g/cm³ and the carbon content of 2.7 wt%, with a grain size of 3.9 nm corresponding to a Si(111) crystal facet.

The methods for evaluating the half cell and the full cell were the same as in Example 1, and the results were summarized in Table 1.

### Example 13

2 kg of silicon suboxide powder (with D10=3.62 µm, D50=7.90 µm, D90=13.40 µm, SPAN=1.24 and a specific surface area of 1.8 m²/g, and with x=1 in the general formula SiOx) together with 0.08 kg of coal pitch powder and 0.01 kg of vapor growth carbon fiber powder were added into the mechanical fusion machine, and mixed for 10 minutes at a linear velocity of 20 m/s at an outer edge of a rotor, to uniformly mix the three starting materials. Subsequently, the linear velocity was kept at 20 m/s, and the temperature was raised to 180°C, held for 0.5 h, and then cooled to room temperature freely. A resulting intermediate product was loaded into a graphite saggar which was then put in a tube furnace, nitrogen protective gas was introduced, and the temperature was raised to 930°C at a rate of 3°C/min, held for 8 h, and then cooled to room temperature freely. A resulting carbonized product was pulverized by a fluted-disk mill, with the maximum linear velocity of 3 m/s at an outer edge of a rotor of the fluted-disk mill. Finally, sieving and magnetic separation were performed to obtain a final product, which had D10=5.91 µm, D50=10.21 µm, D90=17.60 µm, SPAN=1.14, the specific surface area of 1.1 m²/g, the tap density of 1.10 g/cm³ and the carbon content of 3.2 wt%, with a grain size of 3.1 nm corresponding to a Si(111) crystal facet.

The methods for evaluating the half cell and the full cell were the same as in Example 1, and the results were summarized in Table 1.

### Example 14

100 kg of silicon suboxide powder (with D10=2.44 µm, D50=4.55 µm, D90=6.99 µm, SPAN=1.00 and a specific surface area of 1.7 m²/g, and with x=1 in the general formula SiOx) together with 6 kg of coal pitch powder were added to the vertical coating machine, and mixed for 1 h at a linear velocity of 6m/s at the maximum diameter of a stirring component, to uniformly mix the two starting materials. Subsequently, the linear velocity was reduced to 2m/s, meanwhile, nitrogen was introduced as an inert protective gas; then the temperature was raised to 300°C at a rate of 3°C/min, held for 6 h, and then cooled to room temperature freely. A resulting intermediate product was loaded into a graphite saggar which was then put in a pusher kiln, nitrogen protective gas was introduced, and the temperature was raised to 950°C at a rate of 3°C/min, held for 5 h, and then cooled to room temperature freely. A resulting carbonized product was pulverized by a fluted-disk mill, with the maximum linear velocity of 3 m/s at an outer edge of a rotor of the fluted-disk mill. Finally, sieving and magnetic separation were performed to obtain a final product, which had D10=4.92 µm, D50=8.32 µm, D90=14.70 µm, SPAN=1.18, the specific surface area of 1.2 m²/g, the tap density of 1.07 g/cm³ and the carbon content of 3.2 wt%, with a grain size of 3.7 nm corresponding to a Si(111) crystal facet. FIG. 9 is a high magnification SEM image of a secondary particle prepared according to Example 14.

The methods for evaluating the half cell and the full cell were the same as in Example 1, and the results were summarized in Table 1.

### Example 15

100 kg of silicon suboxide powder (the same as in Example 14) together with 6 kg of coal pitch powder and 0.5 kg of Super P were added to the vertical coating machine, and mixed for 1 h at a linear velocity of 6 m/s at the maximum diameter of a stirring component, to uniformly mix the three starting materials. Subsequently, the linear velocity was reduced to 2 m/s, meanwhile, nitrogen was introduced as an inert protective gas; then the temperature was raised to 300°C at a rate of 3°C/min, held for 6 h, and then cooled to room temperature freely. A resulting intermediate product was loaded into a graphite saggar which was then put in a pusher kiln, nitrogen protective gas was introduced, and the temperature was raised to 950°C at a rate of 3°C/min, held for 5 h, and then cooled to room temperature freely. A resulting carbonized product was pulverized by a fluted-disk mill, with the maximum linear velocity of 3 m/s at an outer edge of a rotor of the fluted-disk mill. 2 kg of the pulverized material was loaded into the rotary furnace; the temperature was raised to 950°C at 3°C/min; acetylene and nitrogen were introduced at a flow rate of 0.2 L/min and 0.3 L/min, respectively; a reaction was allowed to proceed for 5 h, then a resultant was cooled to room temperature and taken out. Finally, sieving and magnetic separation were performed to obtain a final product, which had D10=5.38 µm, D50=8.80 µm, D90=15.60 µm, SPAN=1.16, the specific surface area of 1.8 m²/g, the tap density of 0.99 g/cm³ and the carbon content of 5.2 wt%, with a grain size of 3.7 nm corresponding to a Si(111) crystal facet.

The methods for evaluating the half cell and the full cell were the same as in Example 1, and the results were summarized in Table 1.

### Comparative Example 1

Silicon suboxide chunks (with an average size of about 2 cm) were placed in the box furnace, which was then introduced with an argon protective atmosphere; the temperature was raised to 1000°C at 3°C/min for thermal treatment for 2 h; and disproportionated silicon suboxide chunks were hence obtained. The disproportionated silicon suboxide chunks were pulverized to obtain a powder with D10=1.04 µm, D50=4.61 µm, D90=9.01 µm and SPAN=1.73. 2000 g of the obtained silicon suboxide powder was loaded into the rotary furnace, which was then heated to 900°C at 3°C/min and introduced with an acetylene at a flow rate of 0.2 L/min, and with the nitrogen at a flow rate of 0.1 L/min, and the reaction lasted for 10 h to prepare a precursor; and the precursor was placed into the mechanical fusion machine for treatment for 10 min by controlling the linear velocity at the outer edge of the rotor to be 15 m/s, and subsequently mixed, sieved, magnetic separation was carried out, dried and packed to prepare a silicon suboxide composite material with D10=2.05 µm, D50=5.25 µm, D90=9.54 µm, SPAN=1.43, the specific surface area of 5.2 m²/g, the tap density of 0.93 g/cm³, and the carbon content of about 5.2 wt%, and with a grain size of 4.0 nm corresponding to a Si(111) crystal facet.

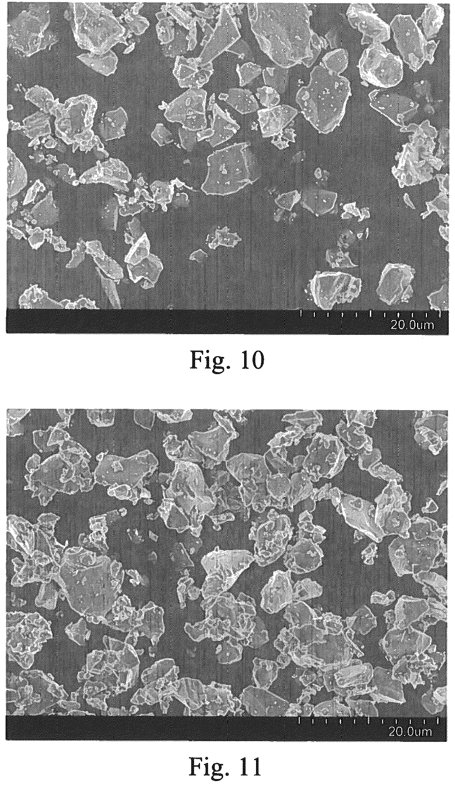

FIG. 10 is an SEM image of the silicon suboxide composite material prepared in Comparative Example 1. It can be seen that the composite material includes many fine particles which are mostly individual primary particles having sharp edges and corners. From the diagram of particle size distribution curve of the silicon suboxide composite material of Comparative Example 1 in FIG. 5, it can be seen that the product in Comparative Example 1 has a wider particle size distribution and higher proportion of small particles than those in Example 6. The particle size distribution curves in FIG. 5 are mass/volume size distribution curves. If the mass/volume size distribution curves are high in small particles region, the count size distribution curves are even orders of magnitude higher in this small-particle region, indicating high specific surface area of this material. Therefore, from FIG. 5, it can be seen that compared with Example 6, the proportion of the count of small particles in Comparative Example 1 is greatly higher, and the specific surface area also increases greatly.

The performances of batteries prepared with the particles from this comparative example were evaluated by referring to the method for evaluating the half cell and the full cell in Example 1, and the results were summarized in Table 1.

### Comparative Example 2

100 kg of silicon suboxide powder (the same as in Example 6) and 10 kg of petroleum pitch powder were loaded into the VC mixer, and mixed for 0.5h after the linear velocity was adjusted to 10 m/s, thereby preparing a precursor 1. The precursor 1 was added to a vacuum kneading machine, and mixed and kneaded for 6 h until the precursor 1 was sticky, where the temperature of the precursor 1 was controlled to be above 250°C by heating via circulating heat transfer oil; then, the precursor 1 was cooled and then quickly transferred to a sheet mill for sheet rolling, where the thickness of a rolled sheet was controlled to be 2.0-5.0 mm; the rolled sheet was cooled and then mechanically pulverized, where a median particle size was controlled to be 2.0-15.0 µm; next, a resulting pulverized material was subjected to hot isostatic pressure treatment, where the pressure was controlled to be 20 MPa and the temperature was controlled to be 250°C; and pressurization was performed for 0.1 h to obtain a precursor 2. The precursor 2 was placed into the roller kiln, nitrogen protective gas was introduced, and the temperature was raised to 1000°C at a rate of 3°C/min, held for 7 h, and then cooled to room temperature freely. Then, the precursor 2 was crushed for 1 h by plow blender at the maximum linear velocity of 3 m/s, and subsequently sieving magnetic separation and drying were carried out to prepare silicon suboxide particles. A resulting material had D 10=3.22 µm, D50=6.77 µm, D90=13.36 µm, SPAN=1.50, the specific surface area of 2.2 m²/g, the tap density of 0.99 g/cm³ and the carbon content of 6.3 wt%, with a grain size of 4.0 nm corresponding to a Si(111) crystal facet.

FIG. 11 is a SEM image of the silicon suboxide particles in Comparative Example 2. It can be seen that the composite material includes many fine particles, many individual primary particles, as well as some loose secondary particles which are formed by combining big and small primary particles and have large specific surface area. From the diagram of particle size distribution curve of the silicon suboxide particles of Comparative Example 2 in FIG. 5, it can be seen that the product in Comparative Example 2 has a particle size distribution wider than that in Example 1, and the proportions of small and big particles are both high.

The performances of batteries prepared with the particles from this comparative example were evaluated by referring to the method for evaluating the half cell and the full cell in Example 1, and the results were summarized in Table 1.

### Comparative Example 3

The process steps of Example 3 were similar to those in Examples 8-10, with an only difference lying in that after the mixture was completed by using the VC mixer at room temperature, a product was directly taken out without granulating process at elevated temperature, and then the product was subsequently carbonized, pulverized, sieved and magnetic separation was carried out. The final product had D10=1.93 µm, D50=8.68 µm, D90=16.22 µm, SPAN=1.65, the specific surface area of 2.2 m²/g, the tap density of 1.02 g/cm³ and the carbon content of 3.9 wt%, with a grain size of 3.9 nm corresponding to a Si(111) crystal facet.

The methods for evaluating the half cell and the full cell were the same as in Example 1, and the results were summarized in Table 1.

**Table 1 Summary of performance testing data**

| | Half cell | | | Full cell | | | | |
|---|---|---|---|---|---|---|---|---|
| | Lithium deinterc alation capacity (mAh/g) | Lithium intercala tion capacity (mAh/g) | Initial Coulom bic efficienc y (%) | Gravimetr ic energy density (Wh/kg) | Initial Coulombi c efficiency (%) | Electrode swelling rate at full charge (%) | 500-cycle capacity retention rate (%) | Battery swelling rate (%) |
| Example 1 | 1593.3 | 2027.1 | 78.6 | 301.0 | 84.1 | 29.4 | 85.3 | 9.0 |
| Example 2 | 1588.5 | 2021.0 | 78.6 | 302.0 | 84.0 | 29.0 | 87.1 | 8.4 |
| Example 3 | 1585.9 | 2010.0 | 78.9 | 301.0 | 84.7 | 28.5 | 87.3 | 7.9 |
| Example 4 | 1584.3 | 2013.1 | 78.7 | 303.0 | 84.8 | 28.2 | 88.2 | 7.8 |
| Example 5 | 1579.9 | 2012.6 | 78.5 | 300.0 | 84.0 | 31.4 | 85.2 | 9.4 |
| Example 6 | 1618.8 | 2018.4 | 80.2 | 310.0 | 85.7 | 28.5 | 89.5 | 7.9 |
| Example 7 | 1610.3 | 2012.9 | 80.0 | 309.0 | 85.6 | 28.0 | 88.4 | 8.1 |
| Example 8 | 1610.2 | 2020.3 | 79.7 | 311.0 | 85.5 | 27.6 | 90.7 | 7.6 |
| Example 9 | 1598.1 | 2015.3 | 79.3 | 307.0 | 84.9 | 28.3 | 89.2 | 7.9 |
| Example 10 | 1593.4 | 2014.4 | 79.1 | 304.0 | 84.7 | 29.7 | 87.7 | 8.6 |
| Example 11 | 1587.7 | 2009.7 | 79.0 | 302.0 | 84.6 | 30.0 | 88.5 | 8.3 |
| Example 12 | 1619.5 | 2050.0 | 79.0 | 306.0 | 84.6 | 28.5 | 86.4 | 8.4 |
| Example 13 | 1598.5 | 2028.6 | 78.8 | 302.0 | 84.2 | 29.6 | 89.9 | 9.2 |
| Example 14 | 1609.8 | 2032.6 | 79.2 | 307.0 | 84.8 | 28.4 | 89.5 | 8.1 |
| Example 15 | 1594.3 | 2018.1 | 79.0 | 302.0 | 84.5 | 27.9 | 90.3 | 7.9 |
| Comparative Example 1 | 1592.2 | 2036.1 | 78.2 | 295.8 | 83.9 | 33.4 | 84.9 | 10.8 |
| Comparative Example 2 | 1587.7 | 2056.6 | 77.2 | 291.0 | 82.7 | 38.5 | 77.1 | 12.4 |
| Comparative Example 3 | 1597.6 | 1976.9 | 77.8 | 289.0 | 83.3 | 40.1 | 73.4 | 13.5 |

The preparation process of the prior art is complicated, and it is difficult to realize mass production by the processes such as mixing and kneading, sheet rolling and hot isostatic pressure treatment. Moreover, the carbon precursor after carbonization tends to adhere and aggregate to adjacent silicon suboxide particles, and the subsequent breaking, pulverization and other processes may damage the carbon coating layer. The material prepared with the prior art has wide particle size distribution and high proportions of both small and big particles, and the battery prepared therefrom is undesirable in Coulombic efficiency, swelling rate and capacity retention and has nonuniform distribution of micro-area swelling in electrode. The secondary particles for the negative electrode material as prepared according to the present invention are dense, narrow in particle size distribution and low in specific surface area, and have been tested to have advantages such as high capacity, high Coulombic efficiency, uniform distribution of areal capacity, low swelling and high capacity retention. Described above are merely preferred embodiments of the present invention, and are not intended to limit the present invention in any forms. Without departing from the scope of the technical solutions of the present invention, any simple modification, equivalent substitution, improvement and the like made by any person skilled in the art to the embodiments above based on the technical essence of the present invention are still construed to fall within the protection scope of the technical solutions of the present invention.

## Claims

1. A silicon oxide particle for an electrode material, **characterized by** comprising:
silicon suboxide particles with a general formula of SiOx; and
a carbon layer, wherein a plurality of said silicon suboxide particles are bonded by the carbon layer, and the plurality of silicon suboxide particles bonded by the carbon layer are coated with the carbon layer.

2. The silicon oxide particle according to claim 1, **characterized in that** the carbon layer is obtained by carbonizing one or a combination of more precursor materials selected from a group consisting of glucose, sucrose, chitosan, starch, critic acid, gelatin, alginic acid, carboxymethyl cellulose, coal pitch, petroleum pitch, phenolic resin, tar, naphthalene oil, anthracene oil, polyacrylic acid, polyacrylic ester, polystyrene, polyvinylpyrrolidone, polyoxyethylene, polyvinyl alcohol, epoxy resin, polyacrylonitrile, and polymethyl methacrylate.

3. The silicon oxide particle according to claim 1, **characterized by** 0.5 ≤ x ≤ 1.5 for the silicon suboxide particles.

4. The silicon oxide particle according to claim 1, **characterized in that** a median particle size D50 of the silicon suboxide particles is between 0.05µm and 20 µm, preferably 0.3-10 µm.

5. The silicon oxide particle according to claim 1, **characterized in that** a mass ratio of the silicon suboxide particles to the silicon oxide particle is in the range of 80 wt% to 99.9 wt%, preferably 90-99.5 wt%.

6. The silicon oxide particle according to claim 1, **characterized by** further comprising a conductive agent uniformly dispersed inside and on an outer surface of the silicon oxide particle.

7. The silicon oxide particle according to claim 6, **characterized in that** the conductive agent is one or a combination of more selected from a group consisting of Super P, Ketjen black, vapor grown carbon fibers, acetylene black, electroconductive graphite, carbon nanotubes and graphene.

8. The silicon oxide particle according to claim 6, **characterized in that** a mass ratio of the conductive agent to the silicon oxide particle is in an amount from 0.01 wt% to 10 wt%, preferably 0.03-5 wt%.

9. The silicon oxide particle according to claim 1 or 6, **characterized by** further comprising one or more, preferably one, additional carbon layers coating on an outer surface of the silicon oxide particle.

10. The silicon oxide particle according to claim 9, **characterized in that** the additional carbon layer is obtained by carbonizing one or a combination of more precursor materials selected from a group consisting of coal pitch, petroleum pitch, polyvinyl alcohol, epoxy resin, polyacrylonitrile and polymethyl methacrylate, or is obtained by performing chemical vapor deposition on any one or a combination of more selected from a group consisting of methane, ethane, ethylene, acetylene, propane, propylene, butane, butene, butadiene, benzene, toluene, xylene, styrene and phenol.

11. The silicon oxide particle according to claim 9, **characterized in that** a mass ratio of the additional carbon layer to the silicon oxide particle is in the range of 0.1 wt% to 10 wt%, preferably 0.3-6 wt%.

12. The silicon oxide particle according to any one of claims 1 to 11, **characterized in that** the silicon oxide particle has D50 between 1µm and 40 µm, preferably 3-20 µm, and more preferably 3.5-10 µm.

13. The silicon oxide particle according to claim 12, **characterized in that** the particle size of the silicon oxide particle meets: (D90-D10)/D50≤ 1.4, preferably (D90-D10)/D50≤1.35.

14. The silicon oxide particle according to claim 12, **characterized in that** the specific surface area of the silicon oxide particle is in the range of 0.1 m²/g to 10 m²/g, preferably 0.3-6 m²/g, and more preferably 0.8-2.7 m²/g.

15. The silicon oxide particle according to claim 14, **characterized in that** a tap density of the silicon oxide particle is ≥0.6 g/cm³, preferably ≥0.8 g/cm³.

16. An application of the silicon oxide particle according to any one of claims 1 to 15 in an electrode material.

17. A negative electrode material, **characterized by** comprising the silicon oxide particle according to any one of claims 1 to 15.

18. An electrode or battery comprising the negative-electrode material according to claim 17.

19. A method for preparing the silicon oxide particle according to claim 1, **characterized by** comprising:
mixing and granulating silicon suboxide particles with a carbon-layer precursor material,
carbonizing composite particles in a non-oxidizing atmosphere, and
pulverizing and sieving the carbonization product, and removing magnetic impurities.

20. The method according to claim 19, **characterized in that**, said mixing and granulating the silicon suboxide particles with the carbon-layer precursor material comprises a step of adding a conductive agent.

21. The method according to claim 19 or 20, **characterized by** further comprising a step of coating the silicon oxide particle with one or more, preferably one, additional carbon layers.

22. The method according to any one of claims 19 to 21, **characterized in that**, the granulating process is performed by using a granulating device comprising a VC mixer, a mechanical fusion machine, a coating machine or a reactor; and
a linear velocity at a maximum diameter of a stirring component in the granulating device is in the range of 1 m/s to 30 m/s during the granulating process performed at a temperature between 100°C and 1050°C for 0.5 hours to 10 hours under protection of an inert atmosphere.

23. The method according to any one of claims 19 to 21, **characterized in that**, the granulating process is performed by using a granulating device comprising a spraying dryer;
the carbonization is performed by using a carbonization device comprising a tube furnace, an atmosphere chamber furnace, a pusher kiln, a roller kiln or a rotary furnace;
a carbonization reaction occurs at a temperature between 600°C and 1200°C for 0.5 hours to 24 hours; and
the non-oxidizing atmosphere is provided by at least one gas selected from nitrogen, argon, hydrogen and helium.

24. The method according to any one of claims 19 to 21, **characterized in that**, the breaking-up is performed by using any one selected from a jet mill, a ball mill, a turbo mill, a Raymond mill, a plow blender and a fluted-disk mill.

25. The method according to claim 21, **characterized in that**, the coating of the additional carbon layers is performed by using any one selected from a mechanical fusion machine, a VC mixer, a high-speed disperser, a coating machine and a reactor.

26. The method according to claim 21, **characterized in that**, the coating of the additional carbon layers is performed with a chemical vapor deposition method comprising: performing chemical vapor deposition in an organic gas and/or vapor at a temperature between 700°C and 1050°C.
